Europäisches Patentamt

European Patent Office

Office européen des brevets

(19)

(11) **EP 1 190 482 B1**

(12) **EUROPÄISCHE PATENTSCHRIFT**

(45) Veröffentlichungstag und Bekanntmachung des Hinweises auf die Patenterteilung:
**03.09.2003 Patentblatt 2003/36**

(21) Anmeldenummer: **00945587.4**

(22) Anmeldetag: **30.05.2000**

(51) Int Cl.7: **H03F 1/26**

(86) Internationale Anmeldenummer:
**PCT/DE00/01757**

(87) Internationale Veröffentlichungsnummer:
**WO 01/003286 (11.01.2001 Gazette 2001/02)**

(54) **VERFAHREN ZUM ENTWURF RAUSCHARMER INTEGRIERTER VERSTÄRKERSCHALTUNGEN**

METHOD FOR DESIGNING INTEGRATED AMPLIFIER CIRCUITS WITH REDUCED NOISE

PROCEDE DE CONCEPTION DE MONTAGES AMPLIFICATEURS INTEGRES A FAIBLE BRUIT

(84) Benannte Vertragsstaaten:
**DE FR GB**

(30) Priorität: **30.06.1999 DE 19930194**

(43) Veröffentlichungstag der Anmeldung:
**27.03.2002 Patentblatt 2002/13**

(73) Patentinhaber: **Infineon Technologies AG**
**81669 München (DE)**

(72) Erfinder: **CATALA, Stéphane**
**D-85737 Ismaning (DE)**

(74) Vertreter: **Epping Hermann & Fischer**
**Ridlerstrasse 55**
**80339 München (DE)**

(56) Entgegenhaltungen:
**US-A- 3 973 214        US-A- 4 631 495**

- **CZYLWIK A: "THEORETISCHE GRENZEN FUER ANPASSUNGSNETZWERKE IN OPTISCHEN EMPFAENGERN" FREQUENZ,DE,SCHIELE UND SCHON GMBH. BERLIN, Bd. 49, Nr. 3/04, 1. März 1995 (1995-03-01), Seiten 58-65, XP000533305 ISSN: 0016-1136**

EP 1 190 482 B1

**Beschreibung**

Verfahren zum Entwurf rauscharmer integrierter Verstärkerschaltungen

Die Erfindung betrifft ein Verfahren zum Entwurf rauscharmer integrierter Verstärkerschaltungen.

Für den Einsatz bekannter integrierter rauscharmer Verstärker muss der Anwender eine Anpassschaltung entwickeln, die die Eingangsimpedanz des rauscharmen Verstärkers optimal an die Ausgangsimpedanz der vorhergehenden Stufe bzw. des vorhergehenden Übertragungsgliedes anpasst. Hierdurch wird die Reflexion der Leistung am Eingang des rauscharmen Verstärkers minimiert.

In dem Dokument Gray, Paul "Analysis and Design of Analog Integrated Circuits" sind auf Seiten 36 und 39 jeweils $\pi$-Ersatzschaltbilder eines Bipolartransistors angegeben. Die Berechnung der Rauscheigenschaften desselben ist auf Seite 776 f. erläutert.

In dem Dokument "Theoretische Grenzen für Anpassungsnetzwerke in optischen Empfängern (Teil II), A. Czylwik, Frequenz, Bd. 49, Nr. 3/04, Seiten 58-65, ist ein Verfahren zur Leistungsund Rauschanpassung eines Feldeffekt-Transisters an eine Photodiode angegeben.

Abhängig von den Rauscheigenschaften des Verstärkers konnte jedoch nicht sichergestellt werden, dass die Rauschzahl des Verstärkers kleiner ist als ein vorgegebener Wert für die Rauschzahl.

Zudem bedeutet die Realisierung und Dimensionierung der Anpassschaltung mittels externer Bauelemente zur Beschaltung des integrierten rauscharmen Verstärkers einen zusätzlichen Aufwand.

Der Erfindung liegt daher die Aufgabe zugrunde, ein Verfahren zum Entwurf rauscharmer integrierter Verstärkerschaltungen zu schaffen, so dass beim Einsatz einer derartigen Verstärkerschaltung keine zusätzliche externe Beschaltung erforderlich ist.

Die Erfindung löst diese Aufgabe mit der Merkmalskombination des Anspruchs 1.

Die Erfindung geht von der Erkenntnis aus, dass durch das Festlegen verschiedener Parameter, wie Prozessparameter bei der Herstellung des integrierten rauscharmen Verstärkers und/oder Geometrieparameter eines oder mehrere Bauelemente des Verstärkers und/oder Bauelementewerte des Verstärkers und/oder den Kollektorstrom bzw. den Drainstrom, eine "Rauschanpassung" an eine vorgegebene Ausgangsimpedanz eines vorhergehenden Übertragungsglieds dann erreichbar ist, wenn die Parameter so gewählt werden, dass die vom Realteil eines komplexen Generatorwiderstands abhängige Rauschzahl $F(R_G)$ des Verstärkers in einem solchen Bereich kleiner ist als ein vorgegebener Sollwert $F_{soll}$ für die Rauschzahl, in dem auch der Realteil der vorgegebenen Ausgangsimpedanz eines dem Verstärker vorgeschalteten beliebigen Übertragungsglieds liegt. Eine echte Rauschanpassung wäre zwar streng genommen nur dann gegeben, wenn der Wert des reellen Generatorwiderstands im Minimum des Verlaufs der Rauschzahl des Verstärkers als Funktion des reellen Generatorwiderstands dem Realteil der Ausgangsimpedanz des vorhergehenden Übertragungsglieds entspricht, jedoch wird in der folgenden Beschreibung auch dann von Rauschanpassung gesprochen, wenn diese Bedingung nur annähernd erfüllt ist.

Sind die vorgenannten Parameter so gewählt, dass Rauschanpassung gegeben ist, so wird erfindungsgemäß die am Kollektor oder der Drain des Transistors der Eingangsstufe des Verstärkers wirksame Last so gewählt, dass sich eine Eingangsimpedanz des Verstärkers ergibt, die im Wesentlichen gleich der konjugiert komplexen Ausgangsimpedanz des vorhergehenden Übertragungsglieds ist, d.h. es wird eine Leistungsanpassung durch die Wahl der Last vorgenommen. Hierbei nützt die Erfindung den Miller-Effekt, nach dem die Kollektor-Basis-Kapazität bzw. die Drain-Gate-Kapazität, welche in der Emitterschaltung eine Bipolartransistors bzw. in der Sourceschaltung eines Feldeffekttransistors multipliziert mit der Spannungsverstärkung die Eingangskapazität der Verstärkerschaltung mit bestimmt.

Da die Spannungsverstärkung in der Regel eine komplexe Größe ist, die nur von der (komplexen) Last am Kollektor bzw. der Drain des Transistors der Eingangsstufe und ggf. von der Induktivität (bzw. der Impedanz) am Emitter bzw. der Source abhängt, kann hierdurch die Eingangsimpedanz nicht nur dem Betrag nach verändert werden, sondern auch innerhalb gewisser Grenzen in der komplexen Ebene gedreht werden, so daß sich durch die geeignete Wahl der Last in (allerdings relativ weiten) Grenzen die Eingangsimpedanz des Verstärkers so bestimmen lässt, dass sie dem konjugiert Komplexen der Ausgangsimpedanz des vorhergehenden Übertragungsglieds entspricht.

Die Stärke des Miller-Effekts hat auf die eingangsbezogenen Rauschquellen im Rauscherzatzschaltbild der Verstärkerschaltung praktisch keine Auswirkung. D.h., die Rauschanpassung und die Leistungsanpassung können nach dem erfindungsgemäßen Verfahren im Wesentlichen unabhängig voneinander vorgenommen werden.

Nach der Ausführungsform des Verfahrens nach der Erfindung wird die Rauschanpassung in einem ersten Schritt und die Leistungsanpassung in einem nachfolgenden zweiten Schritt vorgenommen. Diese Vorgehensweise hat den Vorteil eines geringeren Aufwands, da bei der Rauschanpassung mehrere Größen berücksichtigt werden müssen und die Leistungsanpassung im Wesentlichen nur durch eine entsprechende Wahl der Last als einzige Größe bewirkt werden kann.

Nach der Ausführungsform des erfindungsgemäßen Verfahrens werden für Rauschanpassung zunächst ein (vorzugsweise sinnvoll erscheinender) Satz der maßgeblichen Parameter gewählt. Mit diesen Parametern wird dann die minimale Rauschzahl $F_{opt}$ und der zugehörige optimale reelle Generatorwiderstand $R_{opt}$ ermittelt. Dies kann selbst-

verständlich mit vereinfachten Näherungsbeziehungen oder mit analytischen oder numerischen Simulationsverfahren erfolgen. Entsprechen diese Größen den Vorgaben für die zulässige Rauschzahl und den Realteil der Ausgangsimpedanz der vorhergehenden Stufe, so kann das Verfahren mit der Durchführung der Leistungsanpassung weitergeführt werden.

Selbstverständlich kann jedoch auch noch versucht werden, mit Abänderungen der Parameterwerte eine noch geringere optimale Rauschzahl und einen noch bessere Übereinstimmung des reellen optimalen Generatorwiderstand mit dem Realteil der komplexen Ausgangsimpedanz zu erzielen.

Nach einer Ausführungsform der Erfindung wird die Rauschzahl bzw. die optimale Rauschzahl und der Generatorwiderstand bzw. der optimale Generatorwiderstand für eine Eingangsstufe mit einem Bipolartransistor näherungsweise in Abhängigkeit vom Basisbahnwiderstand und vom Kollektorstrom berechnet. In entsprechender Weise können für eine Eingangsstufe mit einem Feldeffekttransistor die Parameter Gate-Source-Kapazität und Drainstrom verwendet werden.

Für einen Bipolartransistor in Emitterschaltung können hierzu die beiden Näherungsbeziehungen:

$$R_{sopt} \approx \frac{\sqrt{\beta_F}}{g_m}\sqrt{1+2g_m r_b} \qquad F_{opt} \approx 1 + \frac{1}{\sqrt{\beta_F}}\sqrt{1+2g_m r_b}$$

verwendet werden, wobei $\beta_F$ die Gleichstromverstärkung des Transistors bezeichnet, $r_b$ den Basisbahnwiderstand, $g_m$ die Transistorsteilheit und für $g_m$ gilt: $g_m = eI_c/kT$ und wobei e die Ladung eines Elektrons, k die Boltzmann-Konstante, T die absolute Temperatur und $I_c$ den Kollektorstrom bezeichnet.

Weitere Ausgestaltungen des erfindungsgemäßen Verfahrens ergeben sich aus den Unteransprüchen.

Die Erfindung wird nachfolgend anhand der Zeichnung näher erläutert. In der Zeichnung zeigen:

Fig. 1  eine schematische Darstellung eines rauscharmen Verstärkers mit einer Last $Z_L$, der einem beliebigen vorhergehenden Übertragungsglied nachgeschaltet ist;

Fig. 2  ein Rauschersatzschaltbild eines Verstärkers;

Fig. 3  ein Diagramm zur Verdeutlichung der Abhängigkeit der Rauschzahl F eines Verstärkers vom Realteil $R_G$ einer komplexen Generatorimpedanz.

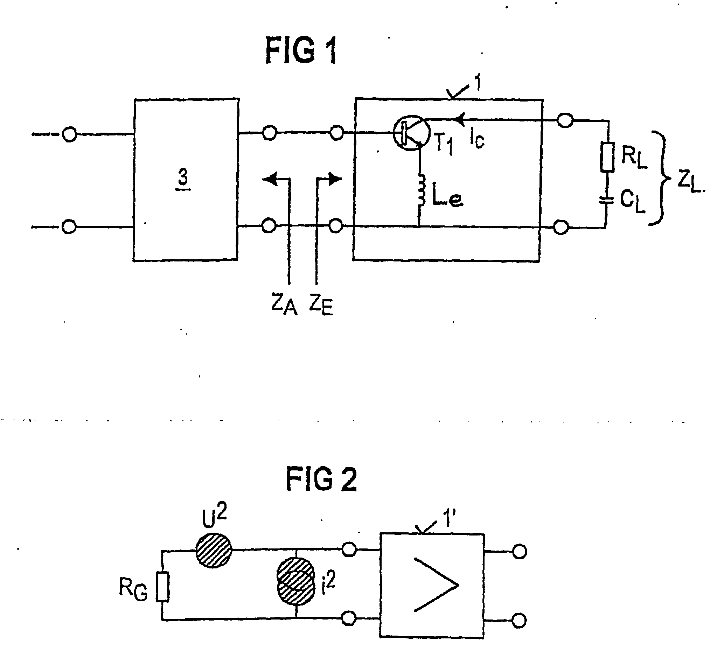

Fig. 1 zeigt eine schematische Darstellung eines rauscharmen Verstärkers 1, der einem beliebigen Übertragungsglied 3 nachgeschaltet ist. Der Verstärker besteht in der vereinfachten Darstellung gemäß Fig. 1 lediglich aus einer Stufe, die einen Bipolartransistor $T_1$ in Emitterschaltung aufweist. Anstelle des Bipolartransistors kann jedoch auch ein Feldeffekttransistor beliebiger Art in Sourceschaltung stehen, für den die folgenden Ausführungen entsprechend gelten, wobei dann selbstverständlich die jeweiligen Parameter des Bipolartransistors durch die entsprechenden Parameter des Feldeffekttransistors zu ersetzen sind.

Die Emitterschaltung ist am Ausgang mit einer komplexen Last $Z_L$ verbunden, die beispielsweise aus einer Reihenschaltung eines reellen Widerstands $R_L$ und eines Kondensators $C_L$ bestehen kann. Dieser Spezialfall einer Komplexen Last wurde in Fig. 1 deshalb gewählt, weil sich durch diese Wahl unter Ausnützen des Miller-Effekts und üblichen Eigenschaften von integrierten Transistoren eine Drehung der Eingangsimpedanz $Z_E$ auf die reelle Achse erreichen lässt (vgl. unten). Dies ist eine häufige Forderung beim Einsatz rauscharmer Verstärker, die an einen reellen Wellenwiderstand von beispielsweise 50 Ω leistungsangepasst werden müssen.

Die komplexe Last $Z_L$ ist jedoch immer die effektiv am Kollektor des Transistors der Eingangsstufe auftretende Last, die die Rückwirkung nachfolgender integrierter Übertragungsglieder beliebiger Art, beispielsweise nachfolgende Verstärkerstufen, und auch eine externe Last umfasst.

Die Induktivität $L_e$ am Emitter der Transistors $T_1$ wird in der Praxis durch einen meist vorhandenen Bonddraht bewirkt, der den Emitter mit dem Masseanschluss verbindet.

Beim Entwurf der Verstärkerschaltung 1 ist zum einen regelmäßig die Forderung zu erfüllen, dass die Rauschzahl F der Verstärkerschaltung kleiner ist als ein vorgegebener Wert $F_{soll}$. Zum anderen muss zur Vermeidung von Reflexionen am Eingang der Verstärkerschaltung 1 eine Leistungsanpassung an das vorhergehende Übertragungsglied 3 vorgenommen werden. D.h. die Ausgangsimpedanz $Z_A$ des vorhergehenden Übertragungsglieds muss gleich dem konjugiert Komplexen der Eingangsimpedanz $Z_E$ der Verstärkerschaltung sein.

Die Rauschzahl der Verstärkerschaltung ist in der Praxis insbesondere abhängig vom Basisbahnwiderstand $r_b$ und vom Kollektorstrom $I_c$ des Transistors $T_1$ der Eingangsstufe der Verstärkerschaltung bei dessen Ausbildung als bipolarer Transistor und von der Gate-Source-Kapazität $C_{GS}$ und dem Drainstrom bei dessen Ausbildung als Feldeffekttransistor sowie vom reellen Generatorwiderstand $R_G$ im Rauschersatzschaltbild des rauscharmen Verstärkers, welches in Fig. 2 dargestellt ist. Dabei wird der Verstärker 1 als idealer nicht rauschender Verstärker 1' aufgefasst. Die Rauscheigenschaften werden durch die beiden (schraffiert dargestellten) Rauschquellen in Form einer Rausch-Spannungsquelle mit dem Schwankungsquadrat der Rauschspannung $u^2$ und in Form einer Rausch-Stromquelle mit dem Schwankungsquadrat $i^2$ des Rauschstroms.

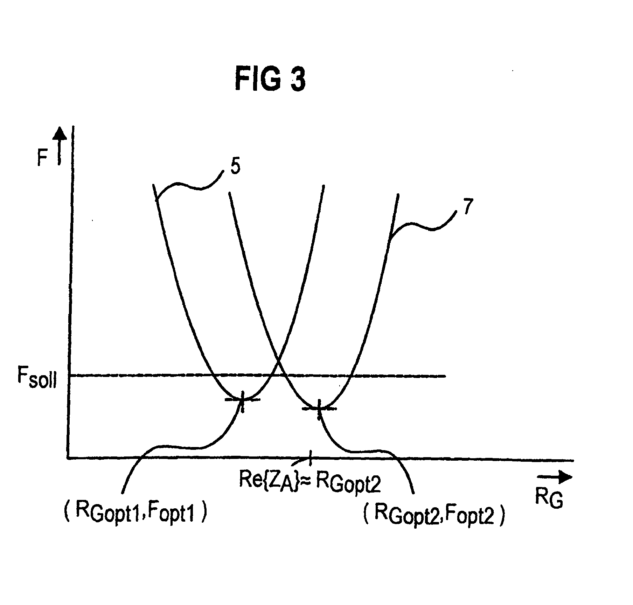

Für übliche Transistoren ergibt sich eine Abhängigkeit der Rauschzahl F vom Realteil $R_G$ einer komplexen Generatorimpedanz $Z_G$, wie sie schematisch in Fig. 3 dargestellt ist.

Des Weiteren ist ganz allgemein die Rauschzahl auch vom Blindleitwert der Generatorimpedanz abhängig. Für einen MOS-Feldeffekttransistor ergibt sich hier beispielsweise ein annähernd parabelförmiger Verlauf, wobei zumindest bei fehlender Korrelation der beiden Rauschquellen die minimale Rauschzahl auftritt, wenn der Eingangsblindleitwert des Verstärkers gleich dem negativen Blindleitwert der Generatorimpedanz ist, d.h. wenn Abstimmung auftritt. Damit kann der Einfluss des Blindanteils der Generatorimpedanz auf die Rauschzahl zumindest näherungsweise vernachlässigt werden, wenn der Verstärker leistungsangepasst dimensioniert bzw. betrieben werden soll.

Erfindungsgemäß wird zum Entwurf der Verstärkerschaltung zunächst ein Wertesatz für diejenigen Parameter gewählt, die die Rauschzahl beeinflussen. Hierbei handelt es sich ganz allgemein um Prozessparameter bei der Realisierung des entsprechenden integrierten Schaltkreises, um Geometrieparameter für die Bauelemente des Schaltkreises und um Bauelementewerte.

Damit ergeben sich Abhängigkeiten für die Rauschzahl F, wie sie in Fig. 3 dargestellt sind. Betrachtet man z.B. die Kurve 5 mit einem Minimum im Punkt $(R_{Gopt1}, F_{opt2})$, so lässt sich die Forderung $F \leq F_{soll}$ erfüllen für den Bereich für den Generatorwiderstand $R_G$, der zwischen den beiden Schnittpunkten der Kurve 5 mit der horizontalen Geraden $F = F_{Soll}$ liegt. Lässt sich diese Bedingung nicht erfüllen, d.h. liegt die Kurve für $F = F(R_G)$ komplett oberhalb der Geraden $F = F_{soll}$, so muss in jedem Fall ein neuer Wertesatz für die Parameter gewählt werden, die die Abhängigkeit der Rauschzahl vom Generatorwiderstand beeinflussen.

Kann die Bedingung $F(R_G) \leq F_{soll}$ erfüllt werden, so muss des Weiteren die Bedingung $R_G \approx Re\{Z_E\}$ erfüllt werden, so dass insgesamt Rauschanpassung gegeben ist.

Kann diese Bedingung nicht erfüllt werden, so muss an dieser Stelle ein neuer Wertesatz für die betreffenden Parameter gewählt werden.

Beispielsweise könnte sich der Fall ergeben, dass mit einem bestimmten Wertesatz für die zu wählenden Parameter zwar die Bedingung $F \leq F_{soll}$ erfüllt werden kann, der Realteil der vorgegebenen Ausgangsimpedanz $Z_A$ jedoch nicht innerhalb des Bereichs für $R_G$ zwischen den Schnittpunkten der Kurve 5 mit der Geraden $F_{soll}$ liegt. In diesem Fall ist für den gewählten Wertesatz für die Parameter keine Rauschanpassung erreichbar. Wird dagegen mit einem neu gewählten Wertesatz die Kurve 7 mit dem Minimum im Punkt $(R_{Gopt2}, F_{opt2})$ in Fig. 3 erzielt, so ergibt sich ein nach rechts verschobener Bereich für einen zulässigen Bereich für einen zulässigen Generatorwiderstand $R_G$.

Liegt der Realteil der vorgegebenen Ausgangsimpedanz in diesem Bereich, so kann der erste Verfahrensschritt beendet werden. Ist dies nicht der Fall, so muss erneut ein anderer Wertesatz für die Parameter gewählt werden.

Aber auch für den Fall, dass sich sowohl die Bedingung $F(R_G) \leq F_{soll}$ als auch die Bedingung $R_G \approx Re\{Z_E\}$ erfüllen lässt, kann versucht werden, einen besseren Wertesatz für die Parameter zu finden. Insbesondere ist es vorteilhaft, dass möglichst der optimale Generatorwiderstand $R_{Gopt}$ dem Realteil der vorgegebenen Ausgangsimpedanz $Z_A$ entspricht. Denn in diesem Punkt ist die Steilheit der Kurve $F(R_G)$ gleich Null und in der Umgebung dieses Punktes ist die Steilheit der Kurve relativ gering, so dass z.B. Fertigungsschwankungen, die eine geringfügige Verschiebung der Kurve $F(R_G)$ sowohl in Richtung der Abszisse als auch in Richtung der Ordinate bewirken können, nur eine relativ gering Auswirkung auf die Rauschzahl F haben. Mit anderen Worten: Bei einem Betrieb eines Verstärkers, der diese Abhängigkeit der Rauschzahl F vom Generatorwiderstand $R_G$ aufweist, mit einem geringfügig vom optimalen Generatorwiderstand $R_G$ abweichenden Generatorwiderstand (der gleich dem Realteil der Ausgangsimpedanz $Z_A$ des vorhergehenden Übertragungsglieds ist), ergibt sich nur eine geringfügig höhere Rauschzahl als im Fall der optimalen "Rauschanpassung".

In einem nächsten Schritt kann dann die Leistungsanpassung des rauscharmen Verstärkers vorgenommen werden. Dies erfolgt nach der Erfindung durch eine entsprechende Wahl der Last $Z_L$ am Kollektor des Eingangstransistors $T_1$, d.h. durch eine entsprechende Festlegung der Spannungsverstärkung der Eingangsstufe. Dabei wird der Effekt ausgenützt, dass eine komplexe Last $Z_L$ durch den Miller-Effekt die Eingangsimpedanz $Z_E$ beeinflusst. Der an sich bekannte Miller-Effekt wird hervorgerufen durch die parasitäre Kollektor-Basis-Kapazität (Bipolartransistor) bzw. die Drain-Gate-Kapazität (Feldeffekttransistor), wobei sich diese parasitäre Kapazität multipliziert mit der Spannungsverstärkung der Eingangskapazität zwischen Basis und Emitter bzw. Gate und Source überlagert.

Da die Spannungsverstärkung als ausschließlich lastabhängig aufgefasst werden kann und auch komplex sein kann, lässt sich die Eingangsimpedanz durch eine entsprechende Wahl der Last $Z_L$ in relativ weiten Grenzen sowohl betragsmäßig als auch in ihrer Richtung in der komplexen Ebene drehen. Dabei wird eine häufige Aufgabe darin bestehen, die Eingangsimpedanz an einen rein reellen Ausgangswiderstand des vorhergehenden Übertragungsglieds anzupassen.

Die Erfindung nützt daher die Tatsache, dass sich eine Veränderung der Last zwar auf die Eingangsimpedanz auswirkt, jedoch die Rauscheigenschaften der Verstärkerschaltung weitestgehend unberührt lässt. Damit wird die im vorstehend erläuterten Schritt erreichte Rauschanpassung durch ein Verändern der Last zum Zweck des Erreichens einer Leistungsanpassung nicht berührt.

Nachfolgend wird dieses Verfahren anhand weitestgehend vereinfachter Beziehungen, d.h. eines sehr vereinfachten Modells zur Beschreibung der Eigenschaften eines Bipolartransistors erläutert. Selbstverständlich lässt sich das Verfahren jedoch auch mit komplizierteren Modellen, die nur noch komplizierte analytische oder numerische Lösungen zulassen, entsprechend durchführen.

Wie vorstehend erwähnt, wird die vom Generatorwiderstand $R_G$ abhängige Rauschzahl F bei Ausbildung des Transistors $T_1$ im wesentlichen durch den Basisbahnwiderstand $r_b$ und den Kollektorstrom $I_c$ und damit von der Steilheit $g_m$ des Transistors $T_1$ bestimmt. Für die Steilheit gilt dabei die Beziehung: $g_m=e/kT \cdot I_c$, wobei mit e die Ladung eines Elektrons, mit T die absolute Temperatur und mit k die Boltzmann-Konstante bezeichnet ist.

Für die optimale Rauschzahl bzw. den optimalen Generatorwiderstand gelten näherungsweise die Beziehungen:

$$R_{gopt} \approx \frac{\sqrt{\beta_F}}{g_m}\sqrt{1+2g_m r_b} \qquad F_{opt} \approx 1 + \frac{1}{\sqrt{\beta_F}} * \sqrt{1+2g_m r_b}$$

Damit kann der optimale Betriebspunkt der Kurve $F(R_G)$ zumindest näherungsweise für bestimmte Werte für $r_b$ und $I_c$ bestimmt werden.

Für das Ausführungsbeispiel eines Verstärkers mit einem Bipolartransistor nach Fig. 1 mit einer aus einem Widerstand $R_L$ und einem Kondensator $C_L$ mit dem Blindwiderstand $X_L=-j/\omega C_L$ bestehenden Last ergeben sich in erster Näherung die folgenden Beziehungen, um eine Eingangsimpedanz $Z_E=|Z_E| \cdot e^{j\phi}$ zu erreichen:

$$X_L = |1+g_m X_e \tan \Phi| \cdot \cos\Phi \cdot \frac{x_\mu}{g_m |Z_E|}$$

$$R_L = \tan[\arctan(X_e g_m) - \Phi] \cdot X_L - \frac{x_\mu}{g_m \cdot X_\pi}$$

Dabei ist mit $X_e$ der Blindwiderstand $X_e=j\omega L_e$ der Emitterinduktivität bezeichnet, mit $X_\mu$ der Blindwiderstand der Kollektor-Basis-Kapazität $X_\mu=j/\omega C_\mu$, mit $g_m$ die bereits bekannte Steilheit des Transistors, mit $|Z_E|$ der Betrag, mit $\Phi$ die Phase der Zieleingangsimpedanz $Z_E=|Z_E| \cdot e^{j\Phi}$ und mit $X_\pi$ die Basis-Emitter-Impedanz in einem $\pi$-Ersatzschaltbild des Bipolartransistors.

Für eine gewünschte reelle Eingangsimpedanz $Z_E$, d.h. wenn $\Phi=0$ gilt, ergibt sich $X_L$ zu $X_L=X_\mu/g_m|Z_E|$ und $R_L$ entsprechend zu $R_L=X_E X_\mu/|Z_E|-X_\mu/g_m X_n$.

Für einen Feldeffekttransistor in Sourceschaltung in der ersten Stufe der zu entwerfenden Verstärkerschaltung lassen sich ähnliche vereinfachte Beziehungen angeben. Da jedoch in der Praxis genauere Modelle zu Beschreibung der Transistoreigenschaften verwendet werden, die jedoch für das Verständnis der vorliegenden Erfindung ohne Belang sind, wird hier auf die Angabe der entsprechenden Beziehungen für einen Feldeffekttransistor ebenso verzichtet wie auf das Einführen und Erläutern der genaueren Modelle.

Das erfindungsgemäße Verfahren zum Entwurf integrierter rauscharmer Verstärker ermöglicht den Entwurf auf einfache Weise in im Wesentlichen zwei Schritten, wobei sich die Schritte im Ergebnis praktisch nicht beeinflussen. Eine übliche externe Beschaltung des Verstärkers ist nicht erforderlich, da der Verstärker bereits für den gewünschten Anwendungsfall, d.h. den Betrieb am Ausgang eines vorhergehenden Übertragungsglieds mit einer bestimmten Ausgangsimpedanz oplimiert ist.

**Patentansprüche**

1. Verfahren zur Herstellung einer rauscharmen integrierten Verstärkerschaltung mit einer Eingangsstufe, die einen Bipolartransistor ($T_1$) in Emitterschaltung oder einen Feldeffekttransistor in Sourceschaltung aufweist, bei dem zur Dimensionierung folgende Schritte durchgeführt werden:

   a) zunächst wird in einem ersten Schritt eine Rauschanpassung der Verstärkerschaltung (1) an den Realteil einer vorgegebenen Ausgangsimpedanz ($Z_A$) eines der Verstärkerschaltung (1) vorgeschalteten Übertragungsglieds (3) dadurch vorgenommen,
dass durch eine erste Festlegung von Prozessparametern bei der Herstellung der integrierten Verstärkerschaltung (1) oder durch eine erste Festlegung von Geometrieparametern ($r_b$) eines oder mehrerer der integrierten Bauelemente oder die Dimensionierung der Bauelementewerte der integrierten Verstärkerschaltung (1) und eine erste Festlegung des Kollektorstroms oder Drainstroms ein Bereich von Widerstandswerten existiert, in dem die von einem reellen Generatorwiderstand ($R_G$) abhängige Rauschzahl ($F(R_G)$) der Verstärkerschaltung kleiner ist als eine vorgegebene Rauschzahl ($F_{soll}$), und daß in diesem Bereich der Wert des Realteils der vorgegebenen Ausgangsimpedanz ($Z_A$) liegt,
wobei für die erste Festlegung der Parameter der integrierten Verstärkerschaltung (1) die minimale Rauschzahl ($F_{opt}$) und der zugehörige optimale Generatorwiderstand ($R_{Gopt}$) ermittelt wird und die zugehörigen Parameter für die Realisierung der Verstärkerschaltung (1) verwendet werden, wenn die minimale Rauschzahl ($F_{opt}$) kleiner oder gleich der vorgegebenen Rauschzahl ($F_{soll}$) und der optimale Generatorwiderstand ($R_{opt}$) innerhalb vorgegebener Toleranzen dem Realteil der vorgegebenen Ausgangsimpedanz ($Z_A$) entspricht und bei dem andernfalls eine neue, die erste ersetzende Festlegung mit anderen, von der ersten Festlegung abweichenden Parametern vorgenommen wird, und
b) in einem nachfolgenden zweiten Schritt wird eine Leistungsanpassung der Eingangsimpedanz ($Z_E$) der Verstärkerschaltung (1) an die vorgegebene Ausgangsimpedanz ($Z_A$) dadurch vorgenommen, dass die am Kollektor des Transistors ($T_1$) wirksame Last ($Z_L$) so gewählt wird, dass sich eine komplexe Spannungsverstärkung ergibt, die infolge des Miller-Effekts eine Eingangsimpedanz ($Z_E$) erzeugt, die gleich der konjugiert komplexen vorgegebenen Ausgangsimpedanz ($Z_A$) ist.

2. Verfahren nach Anspruch 1, bei dem die vom Generatorwiderstand ($R_G$) abhängige Rauschzahl ($F(R_G)$) oder die optimale Rauschzahl ($F_{opt}$) und der optimale Generatorwiderstand ($R_{Gopt}$) für eine Eingangsstufe mit Bipolartransistor näherungsweise in Abhängigkeit von den Parametern Basisbahnwiderstand ($r_b$) und Kollektorstrom ($I_c$) berechnet werden.

3. Verfahren nach Anspruch 1, bei dem die vom Generatorwiderstand ($R_G$) abhängige Rauschzahl ($F(R_G)$) oder die optimale Rauschzahl ($F_{opt}$) und der optimale Generatorwiderstand ($R_{Gopt}$) für eine Eingangsstufe mit Feldeffekttransistor in Abhängigkeit von den Parametern Gate-Source-Kapazität ($C_{GS}$) und Drainstrom berechnet werden.

4. Verfahren nach Anspruch 2, bei dem für einen Bipolartransistor in Emitterschaltung die optimale Rauschzahl $F_{opt}$ und der optimale Generatorwiderstand $R_{opt}$ berechnet werden unter Verwendung der beiden Näherungsbeziehungen:

$$R_{sopt} \approx \frac{\sqrt{\beta_F}}{g_m}\sqrt{1+2g_m r_b} \qquad F_{opt} \approx 1+\frac{1}{\sqrt{\beta_F}}\sqrt{1+2g_m r_b}$$

wobei $\beta_F$ die Gleichstromverstärkung des Transistors bezeichnet, $r_b$ den Basisbahnwiderstand und $g_m$ die Transistorsteilheit und für $g_m$ gilt: $g_m = eI_c/kT$ und wobei e die Ladung eines Elektrons, k die Boltzmann-Konstante, T die absolute Temperatur und $I_c$ den Kollektorstrom bezeichnet.

5. Verfahren nach einem der Ansprüche 1, 2 oder 4, bei dem für einen Bipolartransistor in Emitterschaltung mit einer Emitterinduktivität $L_e$ und einer aus einer Reihenschaltung einer Kapazität $C_L$ und eines ohmschen Widerstands $R_L$ bestehenden Last die Leistungsanpassung unter Verwendung der folgenden Beziehungen ermittelt wird:

$$X_L = |1+g_m X_e \tan\Phi|\cos\Phi \ \frac{X_\mu}{g_m|Z_E|}$$

$$R_L = \tan[\arctan(X_e g_m)-\Phi]\cdot X_L - \frac{X_\mu}{g_m\cdot X_\pi}$$

wobei mit $X_e$ der Blindwiderstand $X_e = j\omega L_e$ der Emitterinduktivität, mit $X_\mu$ der Blindwiderstand der Kollektor-Basis-Kapazität $X_\mu = -j/\omega C_\mu$, mit $g_m$ die Steilheit des Transistors, mit $|Z_E|$ der Betrag und mit $\Phi$ die Phase der Zieleingangsimpedanz $Z_E = |Z_E|\cdot e^{j\Phi}$ und mit $X_\pi$ die Basis-Emitter-Impedanz in einem $\pi$-Ersatzschaltbild des Bipolartransistors bezeichnet ist.

**Claims**

1. Method for producing a low-noise integrated amplifier circuit having an input stage which has a common-emitter bipolar transistor ($T_1$) or a common-source field-effect transistor in which the following steps are carried out for dimensioning purposes:

   a) first, in a first step, noise matching of the amplifier circuit (1) to the real part of a predetermined output impedance ($Z_A$) of a transfer element (3) connected upstream of the amplifier circuit (1) is performed by virtue of the fact that, by means of a first definition of process parameters during the production of the integrated amplifier circuit (1) or by means of a first,definition of geometry parameters ($r_b$) of one or more of the integrated components or the dimensioning of the component values of the integrated amplifier circuit (1) and a first definition of a collector current or drain current, a range of resistances exists in which the noise figure ($F(R_G)$) of the amplifier circuit, said noise figure being dependent on a real generator resistance ($R_g$), is less than a predetermined noise figure ($F_{desired}$), and that the value of the real part of the predetermined output impedance ($F_A$) lies in this range,
   in which case, for the first definition of the parameters of the integrated amplifier circuit (1), the minimum noise figure ($F_{opt}$) and the associated optimum generator resistance ($R_{Gopt}$) are determined and the associated parameters are used for realizing the amplifier circuit (1) if the minimum noise figure ($F_{opt}$) is less than or equal to the predetermined noise figure ($F_{desired}$) and the optimum generator resistance ($R_{opt}$) corresponds, within predetermined tolerances, to the real part of the predetermined output impedance ($Z_A$), and in which otherwise a new definition, replacing the first definition, is performed with other parameters which deviate from the first definition, and
   b) in a subsequent second step, power matching of the input impedance ($Z_E$) of the amplifier circuit (1) to the predetermined output impedance ($Z_A$) is performed by virtue of the fact that the effective load ($Z_L$) on the collector of the transistor ($T_1$) is chosen in such a way as to produce a complex voltage gain which, on account of the Miller effect, generates an input impedance ($Z_E$) which is equal to the complex conjugate of the predetermined output impedance ($Z_A$).

2. Method according to claim 1, in which the noise figure ($F(R_G)$) dependent on the generator resistance ($R_G$) or the optimum noise figure ($F_{opt}$) and the optimum generator resistance ($R_{Gopt}$), for an input stage with a bipolar transistor, are calculated to an approximation as a function of the parameters base bulk resistance ($r_b$) and collector current ($I_c$).

3. Method according to Claim 1, in which the noise figure ($F(R_G)$) dependent on the generator resistance ($R_G$) or the optimum noise figure ($F_{opt}$) and the optimum generator resistance ($R_{Gopt}$), for an input stage with a field-effect transistor, are calculated as a function of the parameters gate-source capacitance ($C_{GS}$) and drain current.

4. Method according to claim 2, in which, for a common-emitter bipolar transistor, the optimum noise figure $F_{opt}$ and the optimum generator resistance $R_{opt}$ are calculated using the two approximation relationships:

$$R_{sopt} \approx \frac{\sqrt{\beta_F}}{g_m}\sqrt{1+2g_m r_b} \qquad F_{opt} \approx 1 + \frac{1}{\sqrt{\beta_F}}\sqrt{1+2g_m r_b}$$

where $\beta_F$ designates the DC gain of the transistor, $r_b$ designates the base bulk resistance and $g_m$ designates the transistor transconductance and the following holds true for $g_m$: $g_m = eI_c/kT$, and where e designates the charge of an electron, k designates Boltzmann's constant, T designates the absolute temperature and $I_c$ designates the collector current.

5. Method according to one of claims 1, 2 or 4, in which, for a common-emitter bipolar transistor with an emitter inductance $L_e$ and a load comprising a series circuit formed by a capacitance $C_L$ and a nonreactive resistance $R_L$, the power matching is determined using the following relationships:

$$X_L = |1 + g_m X_e \tan\Phi|\cos\Phi \frac{\chi_\mu}{g_m|Z_E|}$$

$$R_L = \tan[\arctan(X_e g_m) - \Phi] \cdot X_L - \frac{\chi_\mu}{g_m \cdot X_\pi}$$

where $X_e$ designates the reactance $X_e = j\omega L_e$ of the emitter inductance, $X_\mu$ designates the reactance of the collector-base capacitance $X_\mu = -j/\omega C_\mu$, $g_m$ designates the transconductance of the transistor, $|Z_E|$ designates the magnitude and $\Phi$ the phase of the target input impedance $Z_\varepsilon = |Z_E| \cdot e^{j\phi}$ and $X_\pi$ designates the base-emitter impedance in a $\pi$ equivalentcircuit diagram of the bipolar transistor.

**Revendications**

1. Procédé de fabrication d'un circuit amplificateur intégré à faible bruit, comprenant un étage d'entrée qui comporte un transistor bipolaire monté en émetteur commun ou un transistor à effet de champ monté en source commune, dans lequel les étapes suivantes sont mises en oeuvre en vue du dimensionnement :

   a) il est tout d'abord effectué, dans une première étape, une adaptation en bruit du circuit amplificateur (1) à la partie réelle d'une impédance de sortie prédéterminée ($Z_A$) d'un élément de transmission (3) montée en amont du circuit amplificateur (1) par le fait que
      par une première détermination de paramètres de processus lors de la fabrication du circuit intégré amplificateur (1) ou par une première détermination de paramètres ($r_b$) géométriques d'un ou plusieurs des composants intégrés ou par le dimensionnement des valeurs de composant du circuit intégré amplificateur (1) et par une première détermination du courant de collecteur ou du courant de drain, il existe un domaine de valeurs de résistance dans lequel la valeur de bruit ($F(R_G)$), fonction d'une résistance de générateur réelle ($R_G$), du circuit amplificateur est inférieure à une valeur de bruit prédéterminé ($F_{soll}$), et que la valeur de la partie réelle de l'impédance de sortie prédéterminée ($Z_A$) se trouve dans cette plage, la valeur de bruit minimale et la résistance de générateur optimale associée ($R_{Gopt}$) étant déterminée pour la première détermination des paramètres du circuit intégré amplificateur (1) et les paramètres associés étant utilisés pour la réalisation du circuit amplificateur (1) si la valeur de bruit minimale ($F_{opt}$) est inférieure ou égale à la valeur de bruit prédéterminée ($F_{soll}$) et la résistance de générateur optimale ($R_{opt}$) correspond dans des tolérances prédéterminées, à la partie réelle de l'impédance de sortie prédéterminée ($Z_A$), et une nouvelle détermination, qui remplace la première, étant sinon effectuée avec d'autres paramètres différents de ceux de la première détermination, et
      b) il est effectué, dans une deuxième étape suivante, une adaptation en puissance de l'impédance d'entrée ($Z_E$) du circuit amplificateur (1) à l'impédance de sortie prédéterminée ($Z_A$) en choisissant la charge active ($Z_L$) au niveau du collecteur du transistor ($T_1$) de façon à obtenir une amplification de tension complexe qui génère en conséquence de l'effet Miller une impédance d'entrée ($Z_E$) qui est égale à l'impédance de sortie complexe conjuguée prédéterminée ($Z_A$).

2. Procédé selon la revendication 1, dans lequel la valeur de bruit ($F(R_G)$), fonction de la résistance de générateur ($R_G$), ou la valeur de bruit optimale ($F_{opt}$) et la résistance de générateur optimale ($R_{Gopt}$) sont calculées pour un étage d'entrée avec transistor bipolaire par approximation en fonction des paramètres de la résistance de base ($r_b$) et du courant de collecteur ($I_c$).

3. Procédé selon la revendication 1, dans lequel la valeur de bruit ($F(R_G)$), fonction de la résistance de générateur ($R_G$), ou la valeur de bruit optimale ($F_{opt}$) et la résistance de générateur optimale ($R_{Gopt}$) sont calculées pour un étage d'entrée avec transistor à effet de champ en fonction des paramètres capacité Grille-Source ($C_{GS}$) et courant de drain.

4. Procédé selon la revendication 2, dans lequel pour un transistor bipolaire monté en émetteur commun la valeur de bruit optimale ($F_{opt}$) et la résistance de générateur optimale ($R_{opt}$) sont calculées en utilisant les deux relations d'approximation :

$$R_{opt} \approx \frac{\sqrt{\beta_F}}{g_m} \sqrt{1 + 2g_m r_b} \qquad F_{opt} \approx 1 + \frac{1}{\sqrt{\beta_F}} \sqrt{1 + 2g_m r_b}$$

où $\beta F$ est le gain en courant continu du transistor, $r_b$ est la résistance de base et $g_m$ est la pente du transistor et

pour $g_m$ on a : $g_m = eI_c/kT$ et où e est la charge d'un électron, k est la constante de Boltzmann, T est la température absolue et $I_c$ est le courant dans le collecteur.

**5.** Procédé selon l'une des revendications 1, 2 ou 4, dans lequel, pour un transistor bipolaire monté en émetteur commun d'inductance d'émetteur $L_e$ et de charge constituée d'un montage en série d'une capacité $C_L$ et d'une résistance ohmique $R_L$, l'adaptation en puissance est déterminée en utilisant les relations suivantes :

$$X_L = |1 + g_m X_e tan\Phi| cos\Phi \frac{x_\mu}{g_m|Z_E|}$$

$$R_L = tan[arctan(X_e g_m) - \Phi] X_L \frac{x_\mu}{g_m X_\pi}$$

où $X_e$ est la réactance $X_e = j\omega L_e$ de l'inductance de l'émetteur, $x_\mu$ est la réactance de la capacité base-collecteur $x_\mu = -j/\omega C_\mu$, $g_m$ est la pente du transistor, $|Z_E|$ et $\Phi$ sont respectivement la valeur et la phase de l'impédance d'entrée $Z_E = |Z_E|e^{j\Phi}$ et $X_\pi$ est l'impédance base-émetteur dans un schéma $\pi$-équivalent du transistor bipolaire.

# FIG 1

$Z_A$ $Z_E$

# FIG 2

# FIG 3